# EUROPEAN PATENT APPLICATION

(11) **EP 0 764 517 A1**
(43) Date of publication of application: **26.03.1997**
(21) Application number: 96115239.4
(22) Date of filing: 23.09.1996
(51) Int. Cl.: B29C 70/84, B29C 70/76, B65D 90/34, H05K 5/02

(54) **A process for sealing a ventilation valve to an airtight casing**

(30) Priority: 25.09.1995 IT TO950760
(71) Applicant: MAGNETI MARELLI S.p.A., 20145 Milano (IT)
(72) Inventor: Bertolini, Giorgio, 10040 Leini, (Torino) (IT)
(74) Representative: Quinterno, Giuseppe

(57) **Abstract**

A system for sealing a ventilation valve (V) to an airtight casing or container (I), both components being made of plastics material, by moulding the casing (I) over the valve (V) so that the peripheral edge of the valve (V) is encapsulated in the inner wall of an aperture provided in a wall of the casing (I).

## Description

The present invention relates to a system for fixing a ventilation valve to an airtight container or casing. More specifically, the present invention relates to a process for fixing a ventilation valve to an airtight container or casing.

In the auto-industry airtight casings are widely used, for example, to contain electronic apparatus. Such airtight casings typically have a ventilation valve, of known type, which allows the passage of air but prevents the passage of water or other liquids. A valve of this type is typically constituted by three essential elements:
- an active component, typically a membrane, characterised by the fact that it prevents the passage of water but allows the passage of air,
- a lower support ring, of plastics material,
- an upper closure ring, of plastics material, welded to the lower support ring by ultrasound in such a way that the peripheral portion of the membrane is sealed between the two rings.

In the event that the airtight casing to which the ventilation valve is to be applied is made of plastics material, the problem arises of how to seal the valve to the casing. Methods used in the prior art involve the use of spin welding or of welding by ultrasound or vibration.

However, such fixing systems have some technical disadvantages. A first disadvantage is that, when a valve is fixed by such prior art techniques, the weld may not prove fully airtight. A second disadvantage is due to the fact that, during prior art fixing operations, the ventilation valve itself may be damaged, thus compromising the liquid-tightness of the valve.

The object of the present invention is to provide a fixing process which overcomes the aforesaid disadvantages.

According to the present invention, this object is achieved thanks to a fixing process having the characteristics specified in the claims which follow. A further subject of this invention is a container having a ventilation valve sealed to it by this process.

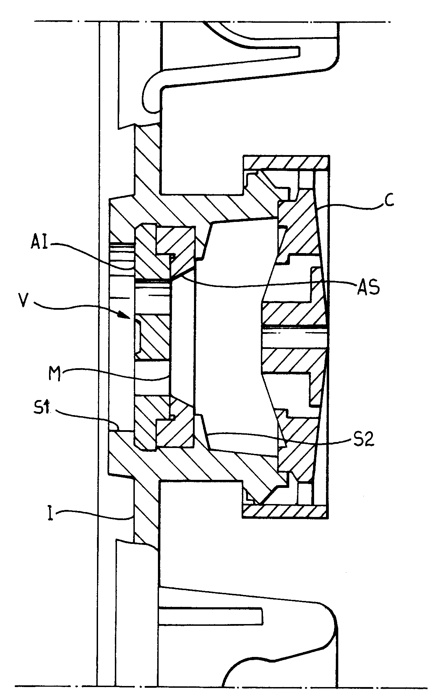

The invention will now be described, purely by way of non-limitative example, with reference to the appended drawings, in which Figure 1 is a schematic cross-section of a ventilation valve applied to a container or casing by the fixing according to the present invention.

Tests carried out by the Applicant have shown that the membrane of the ventilation valve is rather delicate and is particularly sensitive to vibrations, of high, low and medium frequency. If the membrane is damaged by such vibrations, its effectiveness is noticeably impaired.

The present invention consists essentially in fixing the ventilation valve to the airtight casing by a co-moulding operation.

To provide a better understanding of the invention, an airtight casing having a ventilation valve sealed thereto by the system according to the present invention, will be described with reference to Figure 1.

The ventilation valve V, as indicated, is constituted by a lower ring AI and an upper ring AS welded to each other by ultrasound with a membrane M, of the type described earlier, inserted between them. The valve V is inserted in part of a wall of the airtight container I at the site of an aperture, typically of cylindrical form, which is provided in this wall to house the valve V. It can be seen that this aperture is bounded by a substantially cylindrical wall portion and projects in the usual manner from the wall of the casing I. A cap C, also visible in the drawing, is snap-engaged on the projecting wall portion bounding the aperture to protect it.

It can be seen that the peripheral edge of the valve V is inserted in the inner wall of the aperture provided in the wall of the airtight container I. In practice, the peripheral edge of the valve V is enclosed and held between two substantially annular projections or shoulders, S1 and S2, formed on the inner wall bounding the aperture in the wall of the container I. These projections or shoulders S1 and S2 also ensure that the join between the wall of the container I and the ventilation valve V is perfectly airtight since the latter is inserted between the shoulders S1 and S2 by a co-moulding operation.

More specifically, the present invention provides for the use of a moulding process which, by making use of the compatibility of the materials of the container I and of the valve V, both plastics materials, and without subjecting the valve V to mechanical and thermal stress, ensures perfect continuity between those surfaces of the valve V and the container I which are in contact and therefore ensures total airtightness at the pressures under which the components will operate.

One embodiment, currently preferred, provides the following conditions:
- the portion of the container I housing the valve V must avoid any contact whatever with the membrane M,
- the positioning (manual or automatic) must be carried out by manipulation of the valve V by its support structure AI, AS,
- the heat regulating system of the moulding equipment must ensure a negative temperature gradient of at least 7C°/mm in the region of the valve V,
- the system for delivering the plastics material must have several injection points and be near the valve V.

Tests carried out by the Applicant have also shown that the following operating parameters give the best results:
- an operating temperature of the male die of 65°C ± 3C°,
- an operating temperature of the female die of 73°C ± 3C°,
- a temperature of the molten plastics material (PA 6 35% FG) of 260°C ± 2C°,
- a maintenance pressure of 650 bar,
- a filling rate of 50cm³/sec,
- a cooling period of 38 sec,
- cooling out of the mould in the air at 20°C.

Tests carried out by the Applicant showed that the ability to stabilise the moulding process by controlling the operating parameters in real time ensured that the join between the valve V and the container I could be made completely airtight on each occasion.

Naturally, the principle of the invention remaining the same , manufacturing details and embodiments may vary widely from those described and illustrated, without departing from the scope of the present invention.

## Claims

1. A process for sealing a ventilation valve (V) of plastics material to a container or casing (I) of plastics material by fixing a peripheral edge of the ventilation valve (V) to the edge of an aperture formed in a wall of the container (I), characterised in that it includes the step of manufacturing the container (I) by moulding it over the ventilation valve (V).

2. A process according to Claim 1, characterised in that, as a result of the moulding operation, the peripheral edge of the valve (V) is inserted in the inner wall defining the aperture in the container (I).

3. A process according to Claim 2, characterised in that the moulding process involves the formation of a first, substantially annular projection (S1) covering a peripheral portion of a first face of the valve (V).

4. A process according to Claim 3, characterised in that the moulding operation involves the formation of a second, substantially annular projection (S2) covering a peripheral portion of a second face of the valve (V).

5. A process according to any one of Claims 1 to 4, characterised in that the moulding operation involves the injection of a plastics material, which is to form the container (I), through a plurality of injectors.

6. A process according to Claim 5, characterised in that the injectors are located near the aperture in the container and the valve (V).

7. A process according to any one of Claims 1 to 6, characterised in that the moulding operation requires a temperature gradient of more than 7C°/mm in the vicinity of the valve (V).

8. A container (I) having an aperture in which is sealed a ventilation valve (V), characterised in that the valve (V) is sealed to the container(I) by means of a process according to any one of Claims 1 to 8.
